(19) Europäisches Patentamt
European Patent Office
Office européen des brevets

(11) **EP 2 590 231 A2**

(12) # EUROPEAN PATENT APPLICATION

(43) Date of publication:
**08.05.2013 Bulletin 2013/19**

(51) Int Cl.:
***H01L 31/052*** (2006.01)

(21) Application number: **11195216.4**

(22) Date of filing: **22.12.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.11.2011 TW 100140440**

(71) Applicant: **Most Energy Corporation Luzhu Township, Taoyuan County (TW)**

(72) Inventors:
• **Lai, Ming-Hsiung**
**302 Zhubei City, Hsinchu County (TW)**
• **Jiang, Yu-Hsiang**
**235 Zhonge Dist., New Taipei City (TW)**
• **Chen, You-Chi**
**406 Beitun Dist., Taichung City (TW)**

(74) Representative: **2K Patentanwälte Blasberg Kewitz & Reichel Partnerschaft Corneliusstraße 18 60325 Frankfurt a. M. (DE)**

(54) **Condensing lens and photovoltaic system using the same**

(57) A condensing lens includes a lens body and a prism structure. The lens body has a first surface and a second surface opposite to each other. The prism structure is disposed on the second surface of the lens body and has a plurality of annular prism units. The prism structure has at least two focuses in accordance with the annular prism units, and the focuses are distributed on a plane which is parallel to the first surface of the lens body.

FIG. 1

EP 2 590 231 A2

**Description**

BACKGROUND OF THE INVENTION

Field of Invention

The present invention relates to a condensing lens and a photovoltaic power system.

Related Art

Due to the great progress of economy and improvement of life quality, the requirement of energy becomes more and more important. However, since the importance of environmental protection has been noticed recent years, it is desired to develop other power resource such as recyclable energy technologies. At present, the most popular one is the solar energy power system. In general, the solar energy power system includes the heat power system and the photovoltaic power system. Regarding to the photovoltaic power system, it is mainly composed of a condensing lens and a photovoltaic chip such as a monocrystalline silicon solar cell, a polycrystalline silicon solar cell, or a III-V compound solar cell. The configuration of the condensing lens can concentrate the light energy on the photovoltaic chip for generating electricity. In this case, the solar light can be concentrated by the condensing lens and focused on the photovoltaic chip with smaller area, thereby decreasing the material cost of the photovoltaic chip.

Some researches have discussed the sensitivities of different condensing lens with respect to the incident angle of solar light. For example, Chen and Winston disclosed an optimum design by combining the conventional condensing Fresnel lens and the piecewise curve method, which can obtain the concentration efficiency of 67% when the incident angle is $\pm 1.5°$. If the irradiancy map is allowed to move with focus point, the concentration efficiency can still retain a value approximately 90%. Besides, Pablo Benitez et al. further disclosed various analyses and researches about the Fresnel lens cooperated with a secondary concentrator. After studying the previous researches, it is found that the errors on the lens fabrication and the match errors during the assembling can all directly affect the photoelectric conversion efficiency.

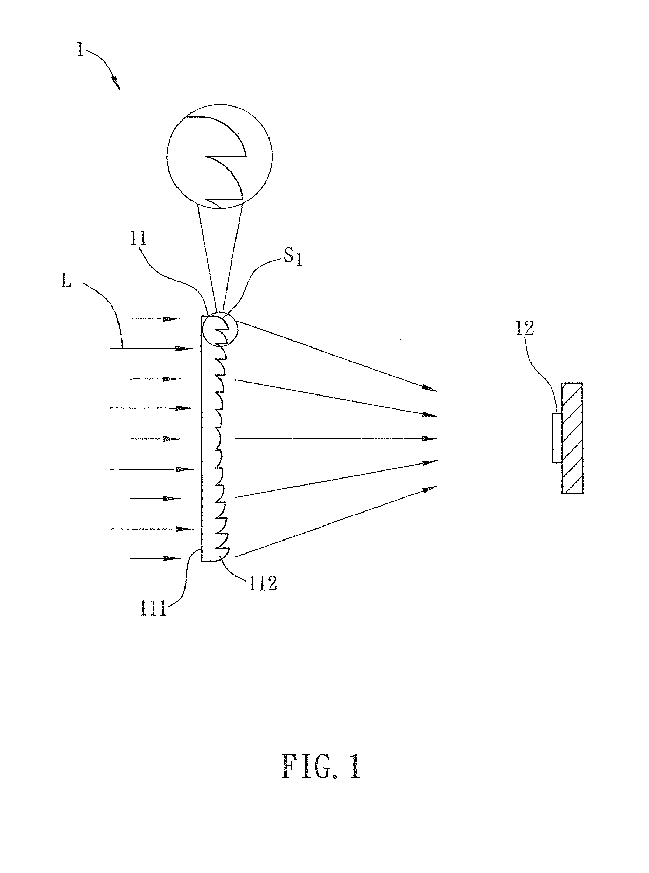

As shown in FIG 1, a conventional photovoltaic power system 1 includes a condensing lens 11 and a photovoltaic chip 12. A first surface 111 of the condensing lens 11 is a planar surface, and another surface opposite to the first surface 111 is configured with a plurality of annular protruding structures 112. In the cross-section view of the condensing lens 11, each annular protruding structure 112 has a cross-section similar to a right triangle, and the lengths the annular surfaces $S_1$ of the annular protruding structures 112 are all the same. The annular surface $S_1$ can be a circle, ellipse, or second-degree parabolic curve. However, these designs usually cause the spherical aberration issue, so that the parallel light beams can not be focused to a single point, thereby decreasing the image quality seriously. Accordingly, many lens sets are necessary to increase the concentration efficiency, which makes the whole system more complex and increases the cost. The photovoltaic chip 12 is disposed at one side of the condensing lens 11 facing the annular protruding structures 112 and receives the light beams L passing through the condensing lens 11, which can conduct the desired photoelectric conversion.

However, the angle of the solar light may change after the time goes by, which can lead the angle shift. When the angle shift occurs, the conventional condensing lens 11 can not concentrate the light beams on the photovoltaic chip 12. As a result, the efficiency of the photovoltaic power system 1 is sufficiently decreased.

Some researchers and manufacturers have invented the sun-tracing system for automatically adjusting the condensing lens 11 and the photovoltaic chip 12 to face the sun directly, thereby maintaining the photoelectric conversion efficiency. However, the power source of the conventional sun-tracing system is usually supplied by the photovoltaic power system 1, so that the net electricity provided by the photovoltaic power system 1 is deceased due to this additional consumption for driving the sun-tracing system.

Therefore, it is an important subject of the present invention to provide a condensing lens and photovoltaic power system that can increase the illumination and concentration efficiency, thereby improving the photoelectric conversion efficiency.

**SUMMARY OF THE INVENTION**

In view of the foregoing subject, an object of the present invention is to provide a condensing lens and photovoltaic power system that can increase the illumination and concentration efficiency, thereby improving the photoelectric conversion efficiency.

To achieve the above object, the present invention discloses a condensing lens includes a lens body and a prism structure. The lens body has a first surface and a second surface opposite to each other. The prism structure is disposed on the second surface of the lens body and has a plurality of annular prism units. The prism structure has at least two focuses in accordance with the annular prism units, and the focuses are distributed on a plane which is parallel to the first surface of the lens body.

In one embodiment of the present invention, the lens body and the prism structure comprise the same material.

In one embodiment of the present invention, the lens body and the prism structure comprise different materials.

In one embodiment of the present invention, an included angle between an annular surface of the annular prism unit and the second surface of the lens body satisfies the following equation:

$$\tan(c) = \frac{r}{n \times \sqrt{r^2 + D^2} - D},$$

Wherein, c represents the included angle, r represents a distance from the annular prism unit to a center point of the lens body, n represents a refraction index of the annular prism unit, and D represents a focus length of the annular prism unit.

In one embodiment of the present invention, the first surface of the lens body receives a plurality of light beams, and the light beams pass through the annular surfaces of the annular prism units and are then concentrated at the focuses.

In addition, the present invention also discloses a photovoltaic power system including a condensing lens and a photovoltaic chip. The condensing lens includes a lens body and a prism structure. The lens body has a first surface and a second surface opposite to each other. The prism structure is disposed on the second surface of the lens body and has a plurality of annular prism units. The photovoltaic chip is disposed at one side of the condensing lens facing the prism structure. The prism structure has at least two focuses in accordance with the annular prism units, and the focuses are distributed on a plane parallel to the first surface of the lens body. The plane is located between the photovoltaic chip and the annular prism units.

In one embodiment of the present invention, the lens body and the prism structure comprise the same material.

In one embodiment of the present invention, the lens body and the prism structure comprise different materials.

In one embodiment of the present invention, the photovoltaic chip is a monocrystalline silicon solar cell, a polycrystalline silicon solar cell, an amorphous silicon solar cell, a compound solar cell, or an organic semiconductor solar cell.

In one embodiment of the present invention, the photovoltaic power system further includes a light collecting device disposed between the condensing lens and the photovoltaic chip for receiving light beams outputted from an annular surface of each annular prism unit.

In one embodiment of the present invention, the photovoltaic power system further includes a heat-dissipating device disposed at another side of the photovoltaic chip away from the prism structure.

In one embodiment of the present invention, an included angle between an annular surface of the annular prism unit and the second surface of the lens body satisfies the following equation:

$$\tan(c) = \frac{r}{n \times \sqrt{r^2 + D^2} - D},$$

Wherein, c represents the included angle, r represents a distance from the annular prism unit to a center point of the lens body, n represents a refraction index of the annular prism unit, and D represents a focus length of the annular prism unit.

In one embodiment of the present invention, the first surface of the lens body receives a plurality of light beams, and the light beams pass through the annular surfaces of the annular prism units and are then concentrated at the focuses.

As mentioned above, the condensing lens and photovoltaic power system of the present invention have a prism structure with a plurality of annular prism units. The prism structure has at least two focuses in accordance with the annular prism units, and the focuses are distributed on a plane parallel to the first surface of the lens body. Accordingly, the illumination and concentration efficiency can be increased so as to improve the photoelectric conversion efficiency

**BRIEF DESCRIPTION OF THE DRAWINGS**

The invention will become more fully understood from the detailed description and accompanying drawings, which are given for illustration only, and thus are not limitative of the present invention, and wherein:

FIG. 1 is a schematic diagram showing a conventional photovoltaic power system;

FIG. 2A is a top view of a condensing lens according to a preferred embodiment of the present invention;

FIG. 2B is a cross-section view of the condensing lens according to the preferred embodiment of the present invention;

FIG. 3 is a schematic diagram of the condensing lens according to the preferred embodiment of the present invention;

FIG. 4 is a schematic diagram of a photovoltaic power system according to the preferred embodiment of the present invention;

FIG. 5 is a graphic diagram showing the illuminations of the conventional condensing lens and the condensing lens according to the preferred embodiment of the present invention;

FIG. 6 is a graphic diagram showing the concentration efficiency (tolerance) of the conventional photovoltaic power system and the photovoltaic power system according to the preferred embodiment of the present invention;

FIG. 7 is a schematic diagram showing another photovoltaic power system according to the preferred embodiment of the present invention; and

FIG. 8 is a schematic diagram showing another photovoltaic power system according to the preferred embodiment of the present invention.

**DETAILED DESCRIPTION OF THE INVENTION**

The present invention will be apparent from the following detailed description, which proceeds with reference to the accompanying drawings, wherein the same references relate to the same elements.

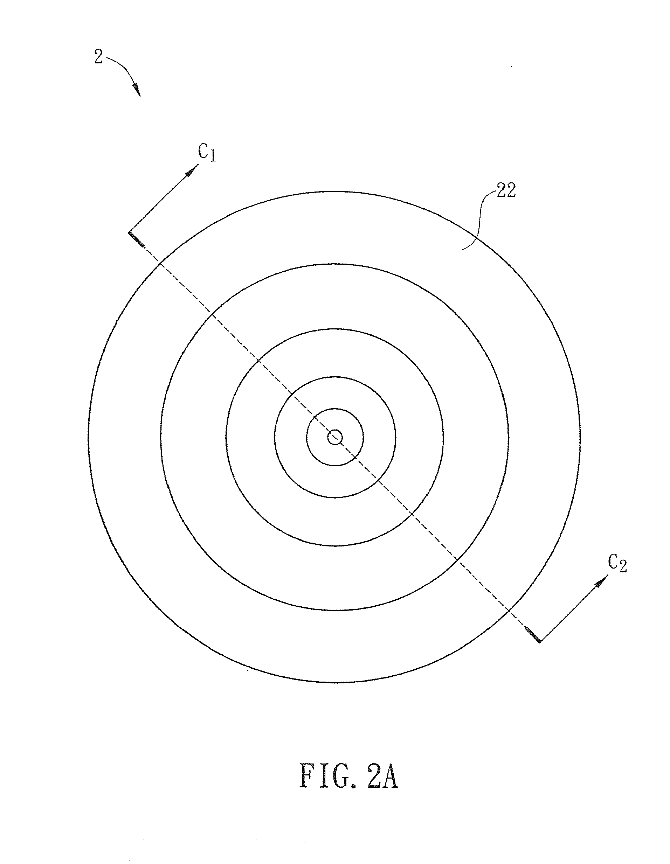

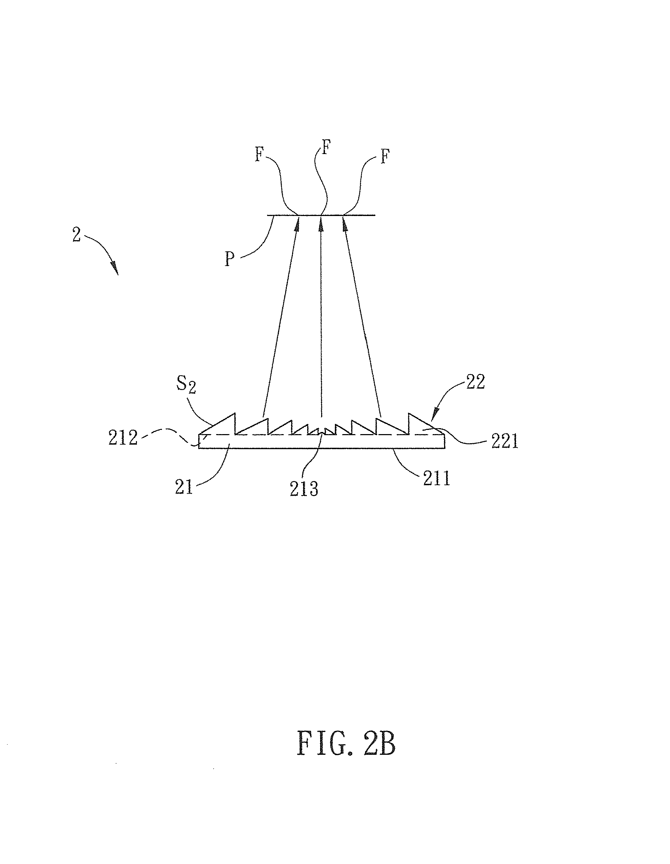

FIG 2A is a top view of a condensing lens 2 according to a preferred embodiment of the present invention, and FIG 2B is a cross-section view along line $C_1$-$C_2$ of FIG. 2B. Referring to FIGS. 2A and 2B, the condensing lens 2 includes a lens body 21 and a prism structure 22. The lens body 21 has a first surface 211 and a second surface 212 opposite to each other. The first surface 211 is a planar surface and is used for receiving the light emitted from external light sources (e.g. solar light). In practice, the material of the lens body 21 includes a transparent material such as glass or transparent polymers. The transparent polymers are, for example, PMMA (polymethly methacrylate), PS (polystyrene), MS (methyl-methacrylate styrene), or PC (polycarbonate).

The prism structure 22 is disposed on the second surface 212 of the lens body 21, and has a plurality of annular prism units 221. The annular prism units 221 are disposed on the second surface 212. In this embodiment, the prism structure 22 has at least two focuses F in accordance with the annular prism units 221, and the focuses F are distributed on a plane P which is parallel to the first surface 211 of the lens body 21. To be noted, the prism structure 22 of this embodiment includes, for example but not limited to, five annular prism units 221.

The material of the prism structure 22 includes a transparent material such as glass or transparent polymers. The transparent polymers are, for example, PMMA (polymethly methacrylate), PS (polystyrene), MS (methyl-methacrylate styrene), or PC (polycarbonate). To be noted, the material(s) of the lens body 21 and the prism structure 22 can be optionally selected from the same or different materials depending on the requirements or designs of the products. Besides, the lens body 21 and the prism structure 22 can be integrally formed as one piece or bonded by an adhering layer (not shown).

In the cross-section view of FIG. 2B, the annular prism unit 221 has a cross-section of a right triangle, and the annular surface $S_2$ of each annular prism unit 221 is the longest side of this right triangle. The length of the longest side of the right triangle in the annular prism unit 221 closer to the center point 213 of the lens body 21 is shorter.

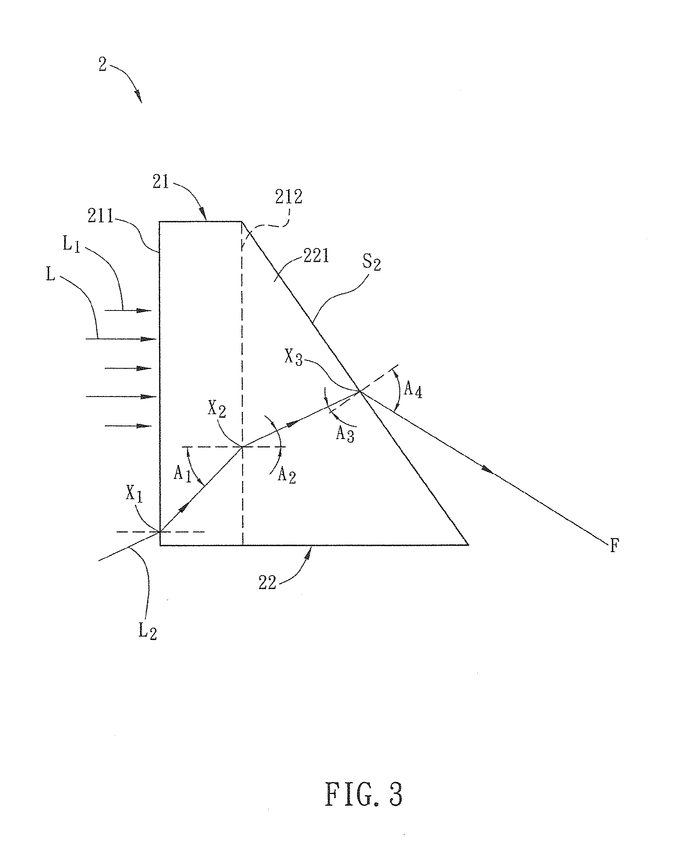

The annular prism unit 221 of the condensing lens 2 will be further described with reference to FIG 3. In this embodiment, the first surface 211 of the lens body 21 receives a plurality of light beams L, which may include the parallel light beams $L_1$ and non-parallel light beams $L_2$. In the following description, the materials of the lens body 21 and the lens structure 22 are different, and only the non-parallel light beams $L_2$ are discussed.

The non-parallel light beams $L_2$ are inputted from an incident point $X_1$ of the first surface 211. When the non-parallel light beams $L_2$ travel to the interface between the second surface 212 and the prism structure 22, which are made of different materials, the refraction of the non-parallel light beams $L_2$ occurs. Accordingly, the non-parallel light beam $L_2$ enters the annular prism unit 221 at the incident point $X_2$ with an incident angle $A_1$ and passes through the interface with an output angle $A_2$. After that, the non-parallel light beams $L_2$ continuously travel to the annular surface $S_2$ and enters an external medium at an incident point $X_3$ with an incident angle $A_3$. Since the annular prism unit 221 and the external medium are made of different materials, the non-parallel light beams $L_2$ can be outputted from the annular surface $S_2$ of the annular prism unit 221 with an output angle $A_4$, and then concentrated at the focuses F. As mentioned above, the non-parallel light beams $L_2$ can have many times of refraction while passing through the annular prism unit 221 of the prism structure 22, thereby achieving the desired concentration effect.

In this embodiment, an included angle c between an annular surface $S_2$ of the annular prism unit 221 and the second surface 212 of the lens body 21 satisfies the following equation:

$$\tan(c) = \frac{r}{n \times \sqrt{r^2 + D^2} - D},$$

Wherein, c represents the included angle, r represents a distance from the annular prism unit 221 to a center point 213 of the lens body 21, n represents a refraction index of the annular prism unit 221, and D represents a focus length of the annular prism unit 221.

According to the above-defined structure, each annular prism unit 221 of the condensing lens 2 can correspond to at least one focus F, and the focuses F corresponding to the annular prism units 221 can be distributed within a certain range on the plane P. For example, the focuses F can be the dots formed within a ring belt on the plane P. In other words, the condensing lens 2 can shift the angles of the light beams from the external light source (solar light), and remain the multiple focuses F within an extremely small range on the plane P.

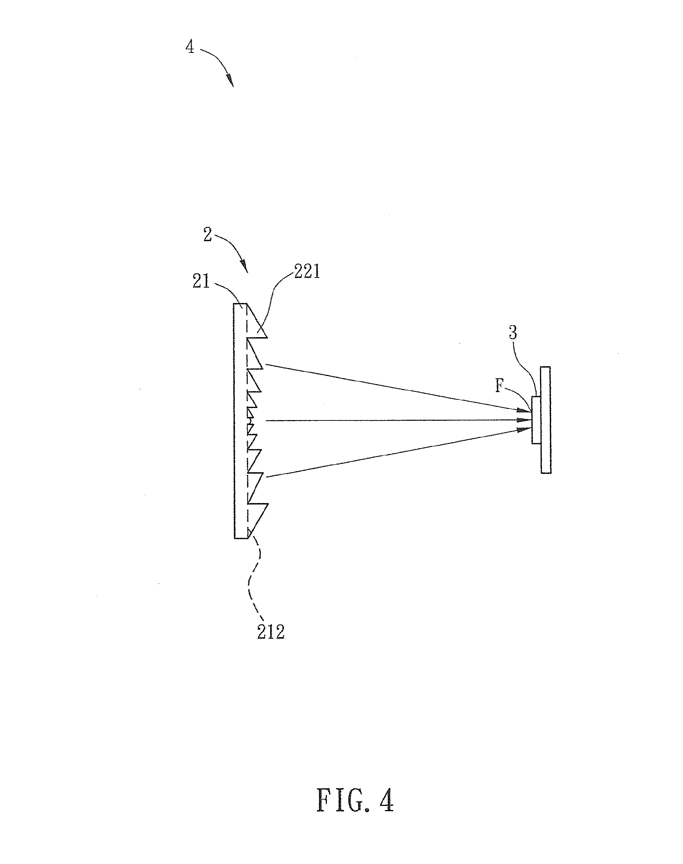

FIG. 4 is a schematic diagram of a photovoltaic power system 4 according to the preferred embodiment of the present invention. Referring to FIG 4, the photovoltaic power system 4 includes a condensing lens 2 and a photovoltaic chip 3. Since the structure and optical features of the condensing lens 2 are described in the above paragraphs, the detailed description thereof will be omitted.

The photovoltaic chip 3 is disposed at one side of the condensing lens 2 facing the prism structure 22. The photovoltaic chip 3 can receive the light beams outputted from the annular prism units 221 of the prism structure 22 and perform the photoelectric conversion. In practice, the photovoltaic chip 3 can be a monocrystalline silicon solar cell, a polycrystalline silicon solar cell, an amorphous silicon solar cell, a compound solar cell, or an organic semiconductor solar cell.

In this embodiment, the focuses F corresponding to the annular prism units 221 of the prism structure 22 can be distributed on the surface of the photovoltaic chip 3. Since the annular prism units 221 of the condensing lens 2 can concentrate the light beams emitted from the external light source at multiple focuses on a plane, the present invention can still allow the focuses F to locate on the surface of the photovoltaic chip 3 even when the solar light is shifted, thereby remaining the photoelectric conversion at high efficiency.

In addition, when the condensing lens 2 is applied to the photovoltaic power system 4, the shift of the solar light is concerned. Accordingly, the positions of the annular prism units 221 on the second surface 212 of the lens body 21 can adjusted based on the shift situation of the solar light. In other words, with respect to multiple focuses F, the annular prism units 221 may not concentric circles.

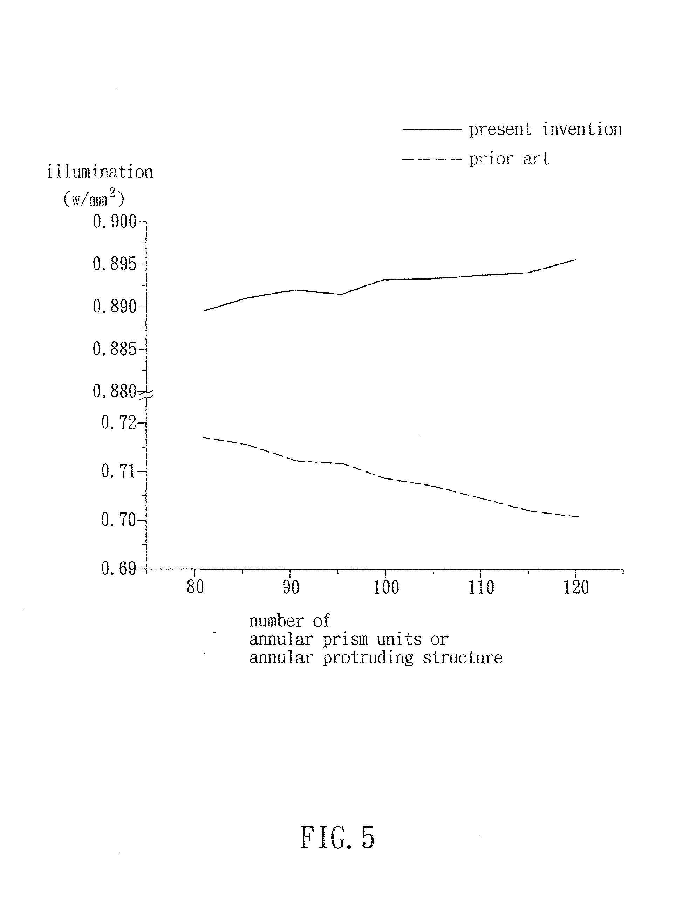

FIG 5 is a graphic diagram showing the illuminations of the conventional condensing lens 11 with different numbers of annular protruding structures 113 and the condensing lens 2 with different numbers of annular prism units 221 of the present invention. Referring to FIG 5, if the annular prism units 221 and the annular protruding structures 113 are all continuously arranged and their amounts are all 100, the illumination of the conventional condensing lens 11 is about 0.708 W/mm$^2$, while the illumination of the condensing lens 2 is about 0.893 W/mm$^2$. Moreover, the illumination of the conventional condensing lens 11 decreases as the number of the annular protruding structures 113 increases. On the contrary, obviously, the illumination of the condensing lens 2 of the present invention increases as the number of the annular prism units 221 increases.

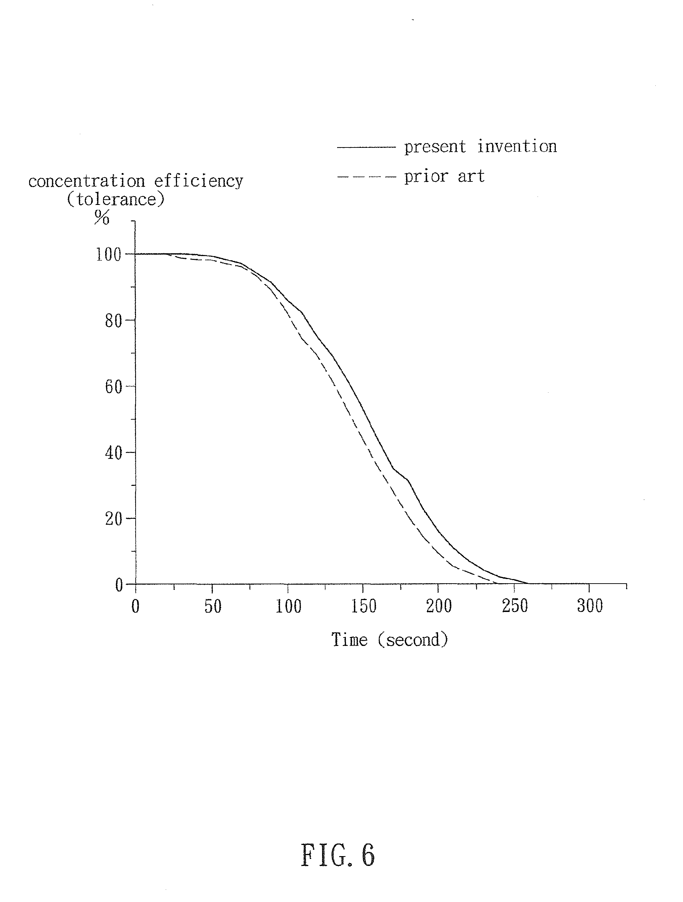

FIG 6 is a graphic diagram showing the concentration efficiency (tolerance) of the conventional photovoltaic power system 1 and the photovoltaic power system 4 of the present invention. Please refer to FIG 6 in view of the following table.

| Time (sec.) | Photovoltaic Power System 1 | | | | Photovoltaic Power System 4 | | | |
|---|---|---|---|---|---|---|---|---|
| | Current | Voltage | Power | Tolerance | Current | Voltage | Power | Tolerance |
| 0 | 1.09 | 2.18 | 2.376 | 100% | 1.1 | 2.17 | 2.387 | 100% |
| 10 | 1.09 | 2.17 | 2.365 | 100% | 1.1 | 2.18 | 2.398 | 100% |
| 20 | 1.09 | 2.17 | 2.365 | 100% | 1.1 | 2.17 | 2.387 | 100% |
| 30 | 1.09 | 2.16 | 2.354 | 99% | 1.1 | 2.16 | 2.376 | 100% |
| 40 | 1.08 | 2.15 | 2.322 | 98% | 1.1 | 2.16 | 2.376 | 100% |
| 50 | 1.08 | 2.16 | 2.333 | 98% | 1.1 | 2.14 | 2.354 | 99% |
| 60 | 1.07 | 2.15 | 2.301 | 97% | 1.1 | 2.13 | 2.343 | 98% |
| 70 | 1.06 | 2.15 | 2.279 | 96% | 1.09 | 2.13 | 2.322 | 97% |
| 80 | 1.06 | 2.09 | 2.215 | 93% | 1.08 | 2.08 | 2.246 | 94% |

(continued)

| | Photovoltaic Power System 1 | | | | Photovoltaic Power System 4 | | | |
|---|---|---|---|---|---|---|---|---|
| Time (sec.) | Current | Voltage | Power | Tolerance | Current | Voltage | Power | Tolerance |
| 90 | 1.04 | 2.04 | 2.122 | 89% | 1.06 | 2.05 | 2.173 | 91% |
| 100 | 1 | 1.94 | 1.940 | 82% | 1.03 | 1.99 | 2.050 | 86% |
| 110 | 0.95 | 1.84 | 1.748 | 74% | 1.01 | 1.94 | 1.959 | 82% |
| 120 | 0.92 | 1.77 | 1.628 | 69% | 0.97 | 1.85 | 1.795 | 75% |
| 130 | 0.88 | 1.66 | 1.461 | 61% | 0.94 | 1.76 | 1.654 | 69% |
| 140 | 0.82 | 1.54 | 1.263 | 53% | 0.88 | 1.65 | 1.452 | 61% |
| 150 | 0.74 | 1.37 | 1.014 | 43% | 0.82 | 1.54 | 1.263 | 53% |
| 160 | 0.67 | 1.23 | 0.824 | 35% | 0.75 | 1.41 | 1.058 | 44% |
| 170 | 0.6 | 1.09 | 0.654 | 28% | 0.67 | 1.26 | 0.844 | 35% |
| 180 | 0.52 | 0.91 | 0.473 | 20% | 0.63 | 1.16 | 0.731 | 31% |
| 190 | 0.43 | 0.76 | 0.327 | 14% | 0.54 | 1.02 | 0.551 | 23% |
| 200 | 0.35 | 0.62 | 0.217 | 9% | 0.46 | 0.85 | 0.391 | 1% |
| 210 | 0.26 | 0.43 | 0.112 | 5% | 0.37 | 0.7 | 0.259 | 11% |
| 220 | 0.21 | 0.33 | 0.069 | 3% | 0.29 | 0.55 | 0.160 | 7% |
| 230 | 0.13 | 0.23 | 0.030 | 1% | 0.21 | 0.4 | 0.084 | 4% |
| 240 | 0.08 | 0.14 | 0.011 | 0% | 0.16 | 0.28 | 0.045 | 2% |
| 250 | 0.05 | 0.08 | 0.004 | 0% | 0.11 | 0.21 | 0.023 | 1% |
| 260 | 0.03 | 0.04 | 0.001 | 0% | 0.06 | 0.13 | 0.008 | 0% |
| 270 | 0.02 | 0.03 | 0.001 | 0% | 0.04 | 0.07 | 0.003 | 0% |
| 280 | 0.01 | 0.02 | 0.000 | 0% | 0.02 | 0.04 | 0.001 | 0% |
| 290 | 0.01 | 0.01 | 0.000 | 0% | 0.01 | 0.02 | 0.000 | 0% |
| 300 | 0.01 | 0.01 | 0.000 | 0% | 0.01 | 0.02 | 0.000 | 0% |

For example, the ratio of the output power of the photovoltaic power system 1 as the Time is 150 seconds, which means the shifted angle of the solar light after 150 seconds, to that without shift is 43%, and the ratio of the output power of the photovoltaic power system 4 as the Time is 150 seconds to that without shift is 53%. Consequently, the photovoltaic power system 4 configured with the condensing lens 2 can provide better concentration efficiency.

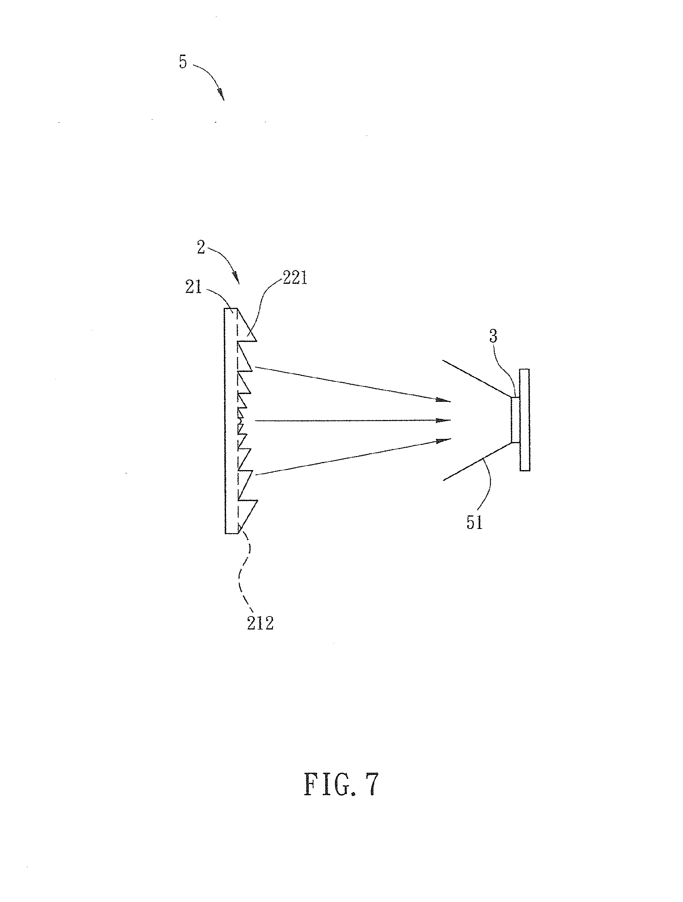

FIG. 7 is a schematic diagram showing another photovoltaic power system 5 according to the preferred embodiment of the present invention. Referring to FIG. 7, the difference between the photovoltaic power systems 4 and 5 is in that the photovoltaic power system 5 further includes a light collecting device 51. In this embodiment, the light collecting device 51 is disposed between the condensing lens 2 and the photovoltaic chip 3 for receiving light beams outputted from an annular surface $S_2$ of each annular prism unit 221. In this case, the light collecting device 51 is a concentrator for collecting the light beams outputted from the annular prism units 221 and allowing the light beams to precisely focus on the photovoltaic chip 3.

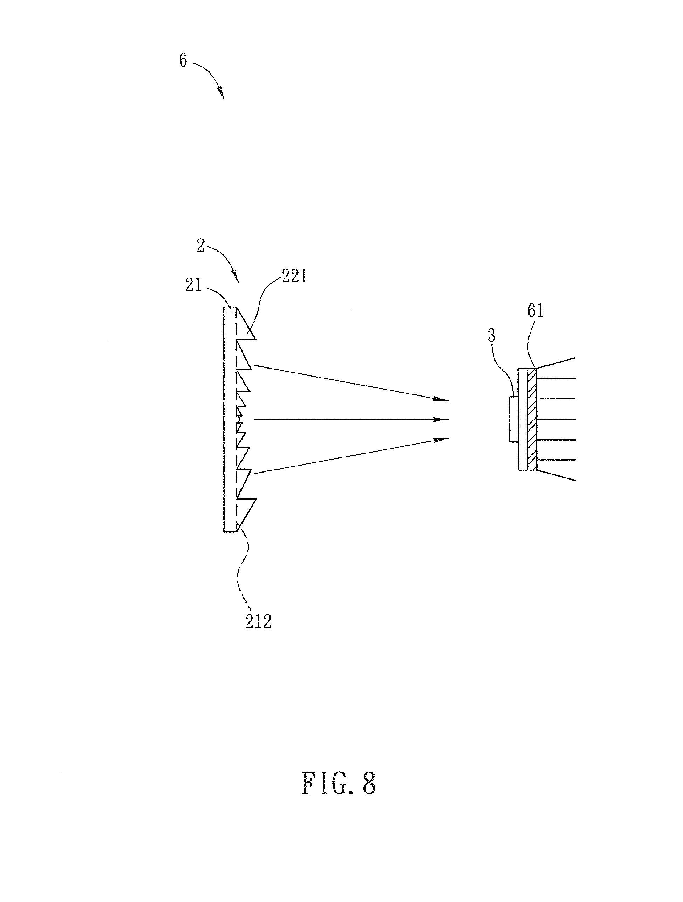

FIG. 8 is a schematic diagram showing another photovoltaic power system 6 according to the preferred embodiment of the present invention. Referring to FIG. 8, the difference between the photovoltaic power systems 4 and 6 is in that the photovoltaic power system 6 further includes a heat-dissipating device 61. In this embodiment, the heat-dissipating device 61 is disposed at another side of the photovoltaic chip 3 away from the prism structure 22 for dissipating the heat generated by the photovoltaic chip 3. In practice, the heat-dissipating device 61 can be a heat sink made of metal materials, or a complex heat sink composed of metal particles and graphite particles.

To be noted, the photovoltaic power systems 4 can further configured with both the light collecting device 51 and the heat-dissipating device 61 for improving the focus accuracy as well as the heat dissipation efficiency.

In summary, the condensing lens and photovoltaic power system of the present invention have a prism structure with a plurality of annular prism units. The prism structure has at least two focuses in accordance with the annular prism units, and the focuses are distributed on a plane parallel to the first surface of the lens body. Accordingly, the illumination and concentration efficiency can be increased so as to improve the photoelectric conversion efficiency

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

**Claims**

1. A condensing lens (2), comprising:

   a lens body (21) having a first surface (211) and a second surface (212) opposite to each other; and
   a prism structure (22) disposed on the second surface of the lens body and
   having a plurality of annular prism units (221), wherein the prism structure has at least two focuses in accordance with the annular prism units, and the focuses are distributed on a plane parallel to the first surface (211) of the lens body.

2. The condensing lens of claim 1, wherein the lens body (21) and the prism structure (22) comprise the same material.

3. The condensing lens of claim 1, wherein the lens body and the prism structure comprise different materials.

4. The condensing lens of any of the preceding claims, wherein an included angle between an annular surface of each of the annular prism units (221) and the second surface (212) of the lens body (21) satisfies the following equation:

$$\tan(c) = \frac{r}{n \times \sqrt{r^2 + D^2} - D},$$

   wherein, c represents the included angle, r represents a distance from the annular prism unit to a center point of the lens body, n represents a refraction index of the annular prism unit, and D represents a focus length of the annular prism unit.

5. The condensing lens of claim 4, wherein the first surface (211) of the lens body (21) receives a plurality of light beams, and the light beams pass through the annular surfaces of the annular prism units (221) and are then concentrated at the focuses.

6. A photovoltaic power system (5), comprising:

   a condensing lens (2) comprising a lens body (21) and a prism structure (22),
   wherein the lens body has a first surface (211) and a second surface (212) opposite to each other, and the prism structure is disposed on the second surface of the lens body and has a plurality of annular prism units (221); and a photovoltaic chip (3) disposed at one side of the condensing lens and facing the prism structure;
   wherein the prism structure (22) has at least two focuses in accordance with the annular prism units, the focuses are distributed on a plane parallel to the first surface (211) of the lens body, and the plane is located between the photovoltaic chip (3) and the annular prism units (221).

7. The photovoltaic power system of claim 6, wherein the lens body and the prism structure comprise the same material.

8. The photovoltaic power system of claim 6, wherein the lens body and the prism structure comprise different materials.

9. The photovoltaic power system of any of claims 6 to 8, wherein the photovoltaic chip (3) is a monocrystalline silicon solar cell, a polycrystalline silicon solar cell, an amorphous silicon solar cell, a compound solar cell, or an organic semiconductor solar cell.

**10.** The photovoltaic power system of any of claims 6 to 9, further comprising:

a light collecting device (51) disposed between the condensing lens (2) and the photovoltaic chip (3) for receiving light beams outputted from an annular surface ($S_2$) of each of the annular prism units (221).

**11.** The photovoltaic power system of any of claims 6 to 10, further comprising:

a heat-dissipating device (61) disposed at another side of the photovoltaic chip (3) away from the prism structure (22).

**12.** The photovoltaic power system of any of claims 6 to 11, wherein an included angle between an annular surface (211) of each of the annular prism units (221) and the second surface (212) of the lens body (21) satisfies the following equation:

$$\tan(c) = \frac{r}{n \times \sqrt{r^2 + D^2} - D},$$

wherein, c represents the included angle, r represents a distance from the annular prism unit to a center point of the lens body, n represents a refraction index of the annular prism unit, and D represents a focus length of the annular prism unit.

**13.** The photovoltaic power system of any of claims 6 to 12, wherein the first surface (211) of the lens body (21) receives a plurality of light beams, and the light beams pass through the annular surfaces of the annular prism units (221) and are then concentrated at the focuses.

FIG. 1

FIG. 2A

FIG. 2B

FIG. 3

FIG. 4

FIG. 5

FIG. 6

FIG. 7

FIG. 8